# EUROPEAN PATENT APPLICATION

(11) **EP 1 666 432 A1**
(43) Date of publication of application: **07.06.2006**
(21) Application number: 04787770.9
(22) Date of filing: 09.09.2004
(51) Int. Cl.: C04B 35/493

(54) **PIEZOELECTRIC CERAMIC COMPOSITION AND PIEZOELECTRIC DEVICE**

(30) Priority: 25.09.2003 JP 2003334195
(71) Applicant: TDK Corporation, Chuo-ku, Tokyo 103-8272 (JP)
(72) Inventor: HIROSE, Masakazu, c/o TDK CORPORATION, Tokyo 1038272 (JP); AZUMA, Tomohisa, c/o TDK CORPORATION, Tokyo 1038272 (JP); NIWA, Yasuo, c/o TDK CORPORATION, Tokyo 1038272 (JP); ABE, Masaru, c/o TDK CORPORATION, Tokyo 1038272 (JP)
(74) Representative: HOFFMANN EITLE
(86) International application number: PCT/JP2004/013106
(87) International publication number: WO 2005/030673

(57) **Abstract**

A piezoelectric ceramic composition excellent in heat resisting properties is provided.

In the piezoelectric ceramic composition including a perovskite compound containing Pb, Zr and Ti as main components, the piezoelectric ceramic composition is made to include Cr as an additive from 0.025 to 0.250 wt% in terms of Cr₂O₃. In the piezoelectric ceramic composition of the present invention, Δk15 (here, Δk15 is the rate of change in electromechanical coupling factor k15, caused by external thermal shock), of the piezoelectric ceramic composition can be controlled to 3.0% or less in absolute value.

## Description

### BACKGROUND OF THE INVENTION

### Field of the Invention

The present invention relates to a piezoelectric ceramic composition suitable for resonators and the like, and a piezoelectric element.

### Description of the Related Art

Piezoelectric ceramic compositions are widely used as the materials for the piezoelectric elements for use in resonators, filters, actuators, ignition elements, ultrasonic motors and the like. Most of the piezoelectric ceramic compositions now being put in practical use are constituted with ferroelectrics having the perovskite structure such as PZT (the PbZrO₃-PbTiO₃ solid solution) based or PT (PbTiO₃) based ferroelectrics having the tetragonal system or the rhombohedral system at around room temperature.

Demand for piezoelectric elements has been growing year by year, and simultaneously demand for enhancing the performance of piezoelectric elements has also been growing. Accordingly, nowadays, the properties such as the electromechanical coupling factor k15 and Qₘₐₓ have been attempted to be improved by adding metal oxides such as Nb₂O₅ and Mn₃O₄, and furthermore by adding metal oxides such as Pb(Mn_{1/3}Nb_{2/3})O₃ to the above described ferroelectrics having the perovskite structure. Additionally, the properties have been attempted to be improved by replacing with Mg_{1/3}Nb_{2/3} and/or Mn_{1/3}Nb_{2/3} part of the Zr and/or Ti components in the PZT based ferroelectrics or part of the Ti component in the PT based ferroelectrics (for example, see Patent Documents 1 to 4). Incidentally, when the resonant frequency is denoted by Fr and the anti-resonant frequency is denoted by Fa (here, Fr < Fa), Qₘₐₓ corresponds to the maximum angle in Q = tan θ (θ: phase angle) within the band involving Fr and Fa.

In these years, concurrently with the miniaturization of electronic devices including communication apparatuses, surface mounting of parts has been rapidly progressed. In surface mounting of parts, a piezoelectric element preliminarily mounted on a substrate is soldered. It is unpreferable that the properties (for example, the resonant frequency, oscillation frequency and the like) of the piezoelectric element largely change from the initial properties after the soldering treatment involving heating. Accordingly, various investigations have been made for the purpose of improving the heat resisting properties of the piezoelectric ceramic compositions.

For example, Patent Document 1 (Japanese Patent Laid-Open No. 2000-103674) has proposed an improvement of the heat resisting properties of a piezoelectric ceramic composition in which to the main component represented by a general formula Pb_{α}[(Mn_{1/3}Nb_{2/3})ₓTi_{y}Zr_{z}]O₃ (in the general formula, 1.00≤ α ≤ 1.05, 0.07 ≤ x ≤ 0.28, 0.42 ≤ y ≤ 0.62, and 0.18 ≤ z ≤ 0.45, x + y + z = 1), Mn₃O₄ is added as an additive from 0.3 to 0.8 wt% in relation to 100 wt% of the main component.

Additionally, Patent Documents 2 to 4 (Patent Document 2: Japanese Patent Laid-Open No. 8-333158, Patent Document 3: Japanese Patent Laid-Open No. 8-333159 and Patent Document 4: Japanese Patent Laid-Open No. 8-333160) have proposed an improvement of the heat resisting properties of piezoelectric ceramic compositions in which to a PZT based main component, Pb(Me_{1/2}Te_{1/2})O₃ (here, Me is at least one metal selected from the group consisting of Mn, Co, Ni and Cu) is added as an additive, and additionally the polarization conditions and the heat treatment conditions are controlled.

In Patent Document 1, the heat resisting properties of a piezoelectric ceramic composition is improved by including Mn as an additive; in an example of the document, there have been obtained samples (the samples No. 2, 3 and 10) in which the rate of change in electromechanical coupling factor k15, observed in the test for heat resisting properties, of each of the samples is 2. 33% in absolute value. However, according to an investigation made by the present inventors, in the case where Mn is made to be contained as an additive, the rate of change in electromechanical coupling factor k15, observed in the test for heat resisting properties, still remains at a high level of 4.0% or more in absolute value.

Additionally, according to the methods described in Patent Documents 2 to 4, rate of change in resonant frequency of the resonator can be made smaller. However, the methods described in Patent Documents 2 to 4 require at least 49 hours in total including the annealing time and the time for the aging treatment subsequent to annealing, and accordingly there is a problem involving the productivity.

### SUMMARY OF THE INVENTION

In view of these circumstances, the present invention provides a technique for obtaining a piezoelectric ceramic composition excellent in heat resisting properties, with a high accuracy and without degrading the productivity.

Toward such an object, the present inventors have found that it is effective to include Cr as an additive, for the purpose of obtaining a piezoelectric ceramic composition excellent in heat resisting properties. More specifically, the present invention provides a piezoelectric ceramic composition including a perovskite compound containing Pb, Zr and Ti as main components, wherein the piezoelectric ceramic composition contains Cr as an additive from 0.025 to 0.250 wt% in terms of Cr₂O₃. It is more preferable that the piezoelectric ceramic composition includes Cr as an additive from 0.030 to 0.200 wt% in terms of Cr₂O₃.

Additionally, it is effective to select a main component having a high Curie temperature Tc in addition to making Cr be contained as an additive in a predetermined content, for the purpose of obtaining a piezoelectric ceramic composition excellent in heat resisting properties. Accordingly, the present invention provides a piezoelectric ceramic composition including a perovskite compound containing Pb, Zr, Ti, Mn and Nb as main components, wherein when the piezoelectric ceramic composition is represented by a formula, Pb_{α}[(Mn_{1/3}Nb_{2/3})ₓTi_{y}Zr_{z}]O₃, α, x, y and z fall respectively in the ranges of 0.95 ≤ α ≤ 1.02, 0.02 ≤ x ≤ 0.15, 0.48 ≤ y < 0.62, and 0.30 ≤ z ≤ 0.50; and the piezoelectric ceramic composition comprises Cr as an additive from 0.025 to 0.250 wt% in terms of Cr₂O₃.

By making the piezoelectric ceramic composition include Cr as an additive from 0.025 to 0.250 wt% in terms of Cr₂O₃, there can be obtained a piezoelectric ceramic composition more excellent than a case proposed by Patent Document 1 where Mn is made to be contained. More specifically, the piezoelectric ceramic composition of the present invention can limit the rate of change in electromechanical coupling factor k15 (hereinafter, the rate of change in electromechanical coupling factor k15 will be simply referred to as "Δk15") , caused by external thermal shock, to 3.0% or less in absolute value, and further to 2.5% or less, if desired. Here, it should be noted that the Δk15 values in the present invention have been obtained on the basis of "24-hours after heat test". More specifically, in the "24-hours after heat test", a specimen of a piezoelectric ceramic composition is wrapped with a sheet of aluminum foil, and immersed in a solder bath at 265°C for 10 seconds, and thereafter the sheet of aluminum foil is removed and the specimen is allowed to stand for 24 hours at room temperature; the Δk15 value is obtained for the specimen from the electromechanical coupling factor k15 measured before being immersed in the solder bath and the electromechanical coupling factor k15 measured after having been allowed to stand for 24 hours.

Additionally, the piezoelectric ceramic composition of the present invention is excellent in heat resisting properties, and moreover, displays a practical electric property such that Qₘₐₓ has a value of 30 or more, and further of 50 or more, if desired. Here, also in the present invention, when the resonant frequency is denoted by Fr and the anti-resonant frequency is denoted by Fa (here, Fr < Fa), Qₘₐₓ corresponds to the maximum angle in Q = tan θ (θ: phase angle) within the band involving Fr and Fa.

By adopting the above described material, as the main component of the piezoelectric ceramic composition, there can be obtained a piezoelectric ceramic composition which has a Curie temperature Tc of 340°C or above, higher than those of the piezoelectric ceramic compositions described in the above described Patent Documents 2 to 4. Concurrently with selecting a composition having a high potential for improving the heat resisting properties as described above, by controlling the preparing conditions, more specifically, the heat treatment conditions, it comes to be possible to make the Δk15 value be 2.0% or less in absolute value, and furthermore, 1.0% or less in absolute value as the case may be . Additionally, it is also possible that the rate of change in oscillation frequency F0 (hereinafter, the change rate of the oscillation frequency F0 will be simply referred to as "ΔF0") and the rate of change in resonant frequency Fr (hereinafter, the rate of change in resonant frequency Fr will be simply referred to as "ΔFr"), caused by external thermal shock, are made to be 0.1% or less in absolute value. The piezoelectric ceramic composition of the present invention displaying practical electric properties and excellent heat resisting properties is suitable for use in resonators.

Additionally, the vibrational mode of the piezoelectric ceramic composition obtained by the present invention can be made to be a thickness-shear mode.

Furthermore, the present invention provides a piezoelectric element including a piezoelectric substrate having a front surface and a back surface opposed to each other with a predetermined distance, and a pair of electrodes arranged respectively on the front surface and the back surface of the piezoelectric substrate. The piezoelectric substrate can be constituted with a sintered body including a perovskite compound containing Pb, Zr, Ti, Mn and Nb as main components, wherein when the sintered body is represented by a formula, Pb_{α}[(Mn_{1/3}Nb_{2/3})ₓTi_{y}Zr_{z}]O₃, α, x, y and z fall respectively in the ranges of 0. 95 ≤ α ≤ 1.02, 0.02 ≤ x ≤ 0. 15, 0.48 ≤ y ≤ 0. 62, and 0.30 ≤ z ≤ 0.50, and the sintered body contains Cr as an additive from 0.025 to 0.250 wt% in terms of Cr₂O₃.

The piezoelectric element of the present invention can display a property such that Δk15 of the piezoelectric element is 3.0 % or less in absolute value.

The piezoelectric element of the present invention may be made to contain Cr and Mn in combination as additives. In this case, it is recommended that the content of Mn is 0.20 wt% or less (not inclusive of 0) in terms of MnCO₃.

According to the present invention, there can be obtained a piezoelectric ceramic composition and a piezoelectric element, both excellent in heat resisting properties, with a high accuracy and without degrading the productivity.

### BRIEF DESCRIPTION OF THE DRAWINGS

FIG. 1 is a diagram showing formula (1) and formula (2) ;
FIG. 2 is a graph illustrating the relation between the electric field and the electric polarization in the case of ferroelectrics;
FIG. 3 is a diagram illustrating the direction of polarization;
FIG. 4 is a diagram showing formula (3) and formula (4) ;
FIG. 5 is a diagram showing formula (5) and formula (6) ;
FIG. 6 is a diagram illustrating an equivalent circuit for a piezoelectric resonator;
FIG. 7 is a sectional view (a sectional view along the thickness direction) of a specimen after vibrating electrodes have been formed on the front and back surfaces of the specimen;
FIG. 8 is a table showing the Δk15 values and Qₘₐₓ values for the samples obtained in Example 1;
FIG. 9 is a table showing the Δk15 values, ΔF0 values and ΔFr values for the samples obtained in Example 2; and
FIG. 10 is a table showing the Δk15 values and Qₘₐₓ values for the samples obtained in Example 3.

### DETAILED DESCRIPTION OF THE PREFERRED EMBODIMENTS

Detailed description will be made below on the piezoelectric ceramic composition according to the present invention on the basis of the embodiments.

### <Chemical Composition>

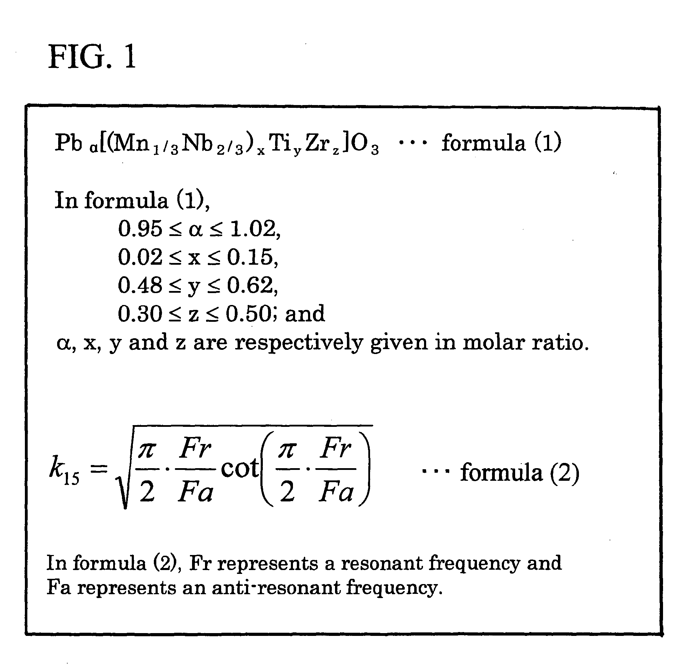

It is preferable that the piezoelectric ceramic composition according to t he present invention includes a perovskite compound containing Pb, Zr and Ti as main components, and particularly has a fundamental composition represented by formula (1) in FIG. 1. The chemical composition as referred to here means a composition of sintered body.

Next, description will be made below on the reasons for imposing constraints on α, x, y and z in formula (1).

The quantity α representing the Pb content is constrained to fall within the range of 0.95 ≤ α ≤ 1.02. When α is smaller than 0.95, it is difficult to obtain a dense sintered body. On the other hand, when α exceeds 1.02, the evaporation amount of Pb becomes large at the time of sintering, and hence it becomes difficult to obtain a sintered body having a uniform microstructure. Accordingly, α is constrained to fall within the range of 0.95 ≤ α ≤ 1.02. The range of α is preferably 0.96 ≤ α ≤ 1.01, and more preferably 0.97 ≤ α ≤ 1.00.

The quantity x determining the Mn content and the Nb content is constrained to fall within the range of 0.02 ≤ x ≤ 0.15. When x is smaller than 0.02, it is difficult to obtain a dense sintered body. On the other hand, when x exceeds 0.15, no desired heat resisting properties can be obtained. Accordingly, x is constrained to fall within the range of 0.02 ≤ x ≤ 0.15. The range of x is preferably 0.03 ≤ x ≤0.12, and more preferably 0.05 ≤ x ≤ 0.11.

The quantity y denoting the Ti content is constrained to fall within the range of 0.48 ≤ y ≤ 0. 62. When y is smaller than 0.48, it is difficult to obtain satisfactory heat resisting properties. On the other hand, when y exceeds 0. 62, the coercive electric field Ec becomes large, and it becomes difficult to perform polarization to a sufficient extent. Accordingly, y is constrained to fall within the range of 0.48 ≤ y ≤ 0.62. The range of y is preferably 0.49 ≤ y ≤ 0.60, and more preferably 0.50 ≤ y ≤ 0.55.

The quantity z denoting the Zr content is constrained to fall within the range of 0.30 ≤ z ≤ 0.50. When z is smaller than 0.30, the coercive electric field Ec becomes large, and it becomes difficult to perform polarization to a sufficient extent. On the other hand, when z exceeds 0.50, it becomes difficult to obtain desired heat resisting properties. Accordingly, z is constrained to fall within the range of 0. 30 ≤ z ≤ 0.50. The range of z is preferably 0.36 ≤ z ≤ 0.46, and more preferably 0.37 ≤ z ≤ 0.42.

It is preferable to set the total of x, y and z be 1 in the formula (1).

The piezoelectric ceramic composition according to the present invention is characterized in that the piezoelectric ceramic composition includes a predetermined content of Cr as an additive. By making the piezoelectric ceramic composition include a predetermined content of Cr, there can be obtained a piezoelectric ceramic composition excellent in heat resisting properties. In relation to Pb_{α}[(Mn_{1/3}Nb_{2/3})ₓTi_{y}Zr_{z}]O₃ in formula (1), the Cr content is preferably 0.025 to 0.250 wt% in terms of Cr₂O₃, more preferably 0.030 to 0.200 wt% in terms of Cr₂O₃, further preferably 0.050 to 0.150 wt% in terms of Cr₂O₃, and yet further preferably 0.050 to 0.100 wt% in terms of Cr₂O₃.

Additionally, Cr is satisfactorily compatible with the following heat treatment recommended by the present invention. By containing Cr as an additive and by applying the heat treatment to be described below in detail, there can be obtained a piezoelectric ceramic composition excellent in heat resisting properties.

The piezoelectric ceramic composition according to the present invention may be made to include Mn as another subsidiary component. The inclusion of Mn is effective for improving the sinterability. In the case where Mn is included as an additive, in relation to Pb_{α}[(Mn_{1/3}Nb_{2/3})ₓTiyZr_{z}]O₃ in formula (1), the Mn content is preferably 0.20 wt% or less (not inclusive of 0) in terms of MnCO₃, more preferably 0.15 wt% or less (not inclusive of 0) in terms of MnCO₃, and further preferably 0.01 to 0.10 wt% in terms of MnCO₃.

When Mn and Cr are added in combination, the total content of Mn and Cr is made to be 0.025 to 0.250 wt%, preferably 0.025 to 0.200 wt%, and more preferably 0.025 to 0.150 wt%.

Here, it should be noted that when Cr and Mn are added in combination, the Cr content ratio in relation to the total content is made to be 50% or more, further preferably 70% or more.

In addition, SiO₂ may be included as an additive to the piezoelectric ceramic composition according to the present invention. The inclusion of SiO₂ is effective for improving the strength of ceramics. When SiO₂ is included, in relation to Pb_{α}[(Mn_{1/3}Nb_{2/3})ₓTiyZr_{z}]O₃ in formula (1) , the SiO₂ content is preferably 0.005 to 0.050 wt%, more preferably 0.005 to 0.040 wt%, and further preferably 0.010 to 0.030 wt%.

The crystal system of the piezoelectric ceramic composition, according to the present invention, having the above described composition, is tetragonal. Additionally, it is preferable that the Curie temperature Tc of the piezoelectric ceramic composition according to the present invention is 340°C or above, and furthermore, 350°C or above as the case may be.

The piezoelectric ceramic composition, according to the present invention, having the above described composition, displays excellent heat resisting properties without dispersion between the samples thereof in such a way that the absolute Δk15 value thereof is 3.0% or less (-3.0% ≤ Δk 15 ≤ 3.0%), and hence is suitable for use in resonators. In this connection, the Δk15 value in the present invention is obtained on the basis of the following procedures.

The electromechanical coupling factor k15 value is measured with a measurement frequency of about 4 MHz by use of an impedance analyzer (4294A manufactured by Agilent Technologies Co., Ltd.). Incidentally, the electromechanical coupling factor k15 is obtained on the basis of formula (2) in FIG. 1. After the electromechanical coupling factor k15 has been measured, the piezoelectric element is warped with a sheet of aluminum foil, and immersed in a solder bath at 265°C for 10 seconds; and thereafter the piezoelectric element is taken out from the aluminum foil wrapping, and is allowed to stand for 24 hours at room temperature in air. After this test for heat resisting properties, the electromechanical coupling factor k15 is once again measured, and the Δk15 is thereby obtained. In the following examples, the Δk15 values have been obtained on the basis of the same procedures.

### <Manufacturing Method>

Now, description will be made below on the preferable manufacturing method of the piezoelectric ceramic composition according to the present invention, by following the sequence of the steps of the method.

Incidentally, in the manufacturing method of the piezoelectric ceramic composition to be described below, it is preferable that the composition of the piezoelectric ceramic composition is of course made to be the above described composition, and moreover, the polarization conditions and the heating treatment conditions are constituted as described below.

### (Starting Material Powders and Weighing Out)

As the starting materials for the main components, there are used powders of oxides or powders of compounds to be converted to oxides when heated. More specifically, Pb0 powder, TiO₂ powder, ZrO₂ powder, MnCO₃ powder, Nb₂O₅ powder and the like can be used. The starting material powders are weighed out respectively so that the composition represented by formula (1) may be actualized.

Next, in relation to the total weight of the weighed out powders, Cr is added as an additive from 0.025 to 0.250 wt% in terms of Cr₂O₃. As the starting material powder for the subsidiary component, Cr₂O₃ powder and the like can be used. In addition to Cr as an additive, Mn may be added at 0.20 wt% or less in terms of MnCO₃. In this case, the MnCO₃ powder which has been prepared as a starting material for a main component can be used. When SiO₂ is to be included, additionally SiO₂ powder is prepared. It is recommended that the mean particle size of each of the starting material powders is appropriately selected within the range of 0.1 to 3.0 µm.

Incidentally, without restricting to the above described starting material powders, a powder of a composite oxide containing two or more metals may be used as a starting material powder.

### (Calcination)

The starting material powders are subjected to wet mixing and then subjected to a calcination while being maintained at temperatures falling within the range from 700 to 950°C for a predetermined period of time. This calcination is recommended to be conducted under the atmosphere of N₂ or air, setting the maintaining time within the range from 0.5 to 5.0 hours.

Incidentally, although description has been made above for the case where the powders of the main components and the subsidiary component are mixed together, and then both of them are subjected to calcination, the timing for adding the starting material of the subsidiary component is not limited to the above described timing. Alternatively, for example, firstly the powders of the main components are weighed out, mixed, calcined and pulverized; then, to the main component powder thusobtained after calcination and pulverization, the starting material powder of the subsidiary component may be added in a predetermined content to be mixed with the main component powder.

### (Granulation and Compacting)

The pulverized powder is granulated for the purpose of smoothly carrying out a subsequent compacting step. In this case, the pulverized powder is added with a small amount of an appropriate binder such as polyvinyl alcohol (PVA), and subjected to spraying and drying. Then, the thus granulated powder is compacted by pressing under a pressure of 200 to 300 MPa to obtain a compacted body having a desired shape.

### (Sintering)

After the binder, added at the time of molding, has been removed from the molded body, the molded body is heated and maintained at temperatures within the range from 1100 to 1250°C for a predetermined period of time to obtain a sintered body. In this connection, the atmosphere is recommended to be N₂ or air. The maintaining time period of the heating is recommended to be appropriately selected within the range from 0.5 to 4 hours.

### (Polarization)

After electrodes for the polarization have been formed on the sintered body, the polarization is carried out. The polarization is conducted under the conditions such that the polarization temperature falls within the range from 50 to 300°C, and an electric field of 1.0 to 2.0 Ec (Ec being the coercive electric field) is applied to the sintered body for 0.5 to 30 minutes.

When the polarization temperature is lower than 50°C, the Ec is elevated and accordingly the voltage needed for polarization becomes high, so that the polarization is made difficult. On the other hand, when the polarization temperature exceeds 300°C, the insulation property of the insulating oil is markedly lowered, so that the polarization is made difficult. Consequently, the polarization temperature is made to fall within the range from 50 to 300°C. The polarization temperature is preferably 60 to 250°C, and more preferably 80 to 200°C.

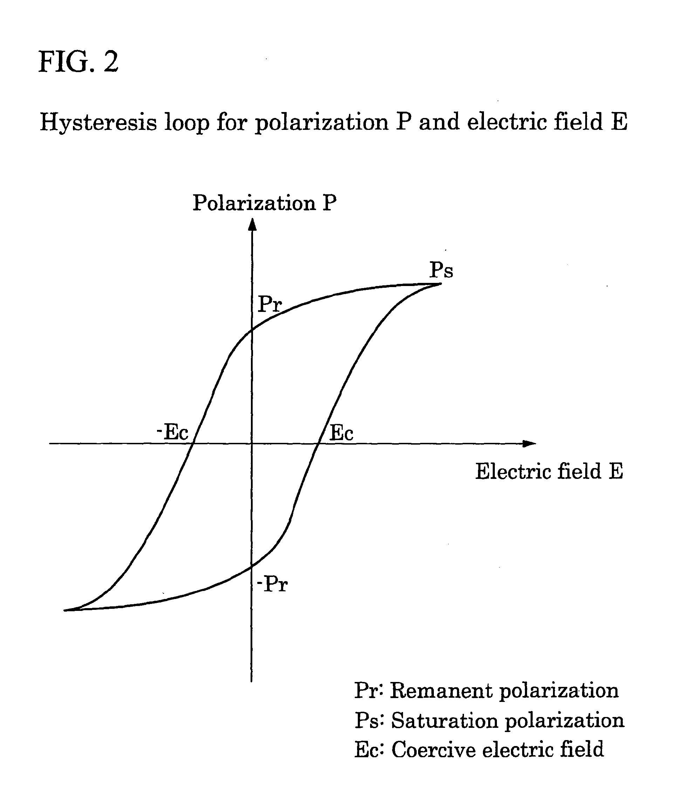

Additionally, when the applied electric filed is lower than 1.0 Ec, the polarization does not proceed. On the other hand, when the applied electric field is higher than 2.0 Ec, the actual voltage becomes high, so that the dielectric breakdown of sintered body tends to be occurred and accordingly it becomes difficult to prepare a piezoelectric ceramic composition. Accordingly, the electric filed to be applied in the polarization is made to be 1.0 to 2.0 Ec. The applied electric field is preferably 1.1 to 1. 8 Ec, and more preferably 1.2 to 1.6 Ec. In this connection, the relation between the electric field E and the polarization P in the case of ferroelectrics is shown in FIG. 2. As shown in FIG. 2, when the sense of the electric field is reversed to apply the reversed electric field, the polarization vanishes at the field of -Ec; this electric filed is the coercive electric field Ec.

When the polarization time is less than 0.5 minute, the polarization is not progressed to a sufficient extent, so that the properties cannot be attained to a sufficient extent. On the other hand, when the polarization time exceeds 30 minutes, the time required for the polarization becomes long, so that the production efficiency is degraded. Accordingly, the polarization time is made to be 0.5 to 30 minutes. The polarization time is preferably 0.7 to 20 minutes, and more preferably 0.9 to 15 minutes.

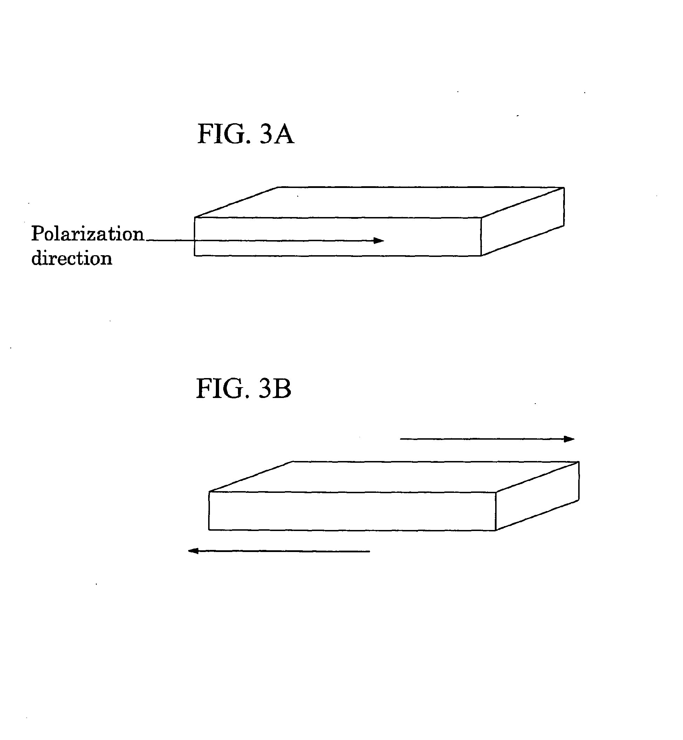

The polarization is conducted in a bath of an insulating oil such as a silicon oil heated to the above described temperature. Incidentally, the polarization direction is determined according to the desired vibrational mode. In this connection, when the desired vibrational mode is a thickness-shear mode, the polarization direction is taken as shown in FIG. 3A; the thickness-shear vibration is such a vibration as illustrated in FIG. 3B.

By undergoing the above described steps, there can be obtained the piezoelectric ceramic composition of the present invention. The piezoelectric ceramic composition of the present invention displays excellent properties such that the absolute value of Δk15 is 3.0% or more and Qₘₐₓ is 30 or more. By making the composition of the ceramic composition and the conditions for polarization more preferable, the absolute value of Δk15 can be made to be 2.0% or less, and furthermore, 1.5% or less as the case may be.

The piezoelectric ceramic composition (sintered body) is lapped to a desired thickness, and thereafter vibrating electrodes are formed. Then, the piezoelectric ceramic composition is cut into a desired shape to function as a piezoelectric element. The shape of the piezoelectric element can be, for example, a rectangular parallelepiped; in this case, the dimension of the piezoelectric element can be set to be such that the length is 1 to 10 mm, the width is 0.3 to 5.0 mm, and the thickness is 0.05 to 0.60 mm. When the vibrational mode of the piezoelectric element is selected to be thickness -shear mode, a pair of vibrating electrodes are formed respectively on the front and back surfaces of the sintered body (a piezoelectric substrate) having the front and back surfaces opposed to each other with a predetermined distance.

The piezoelectric ceramic composition of the present invention is suitably used as the materials for the piezoelectric elements for use in resonators, filters, actuators, ignition elements, ultrasonic motors and the like.

Additionally, by applying a heat treatment, under the following conditions, to the piezoelectric ceramic composition of the present invention containing a predetermined amount of Cr as an additive, a piezoelectric ceramic composition more excellent in heat resisting properties can be obtained.

### (Heat Treatment)

It is preferable that a heat treatment is conducted after the polarization and before the formation of the vibrating electrodes. No particular constraint is imposed on the atmosphere of the heat treatment, and the heat treatment can be conducted, for example, in air.

In the heat treatment of the present embodiment, the heat treatment temperature is appropriately set within the range equal to or higher than 0.68 times the Curie temperature Tc and lower than the Curie temperature Tc. If the heat treatment temperature is equal to or higher than the Curie temperature Tc, depolarization comes to occur. Accordingly, the heat treatment temperature is set to be lower than the Curie temperature Tc, and preferably to be 0.98 or less times the Curie temperature Tc. On the other hand, if the heat treatment temperature is lower than 0.68 times the Curie temperature Tc, the piezoelectric element cannot enjoy sufficiently the advantage such that the heat resisting properties are improved by the heat treatment.

The heat treatment temperature is preferably 0. 74 to 0. 96 times the Curie temperature Tc, and more preferably 0.80 to 0.90 times the Curie temperature Tc. Incidentally, the Curie temperature Tc of the piezoelectric ceramic composition of the present invention is, as described above, 340°C or above, and furthermore, 350°C or above as the case may be.

Additionally, in the heat treatment of the present embodiment, the heat treatment time is set to be 1 to 100 minutes. If the heat treatment time is less than 1 minute, there cannot be produced a sufficient effect such that the heat resisting properties are improved by the heat treatment. If the heat treatment time exceeds 100 minutes, the time needed for the heat treatment step is elongated, so that the heat treatment time exceeding 100 minutes is not preferable. The heat treatment time is preferably 1 to 40 minutes, and more preferably 1 to 20 minutes. As will be shown in the examples to be described later, when the heat treatment temperature is somewhat high in such a way that the heat treatment temperature is 0.74 times the Curie temperature Tc or higher and lower than the Curie temperature Tc, there can be enjoyed an effect such that the heat resisting properties are improved by the heat treatment even for a short heat treatment time less than 30 minutes. On the other hand, when the heat treatment temperature is somewhat low in such a way that the heat treatment temperature is 0.68 times the Curie temperature Tc or higher and lower than 0.74 times the Curie temperature Tc, it is preferable that the heat treatment time is set to be 30 minutes or more.

Additionally, in this heat treatment step, it is recommended that the heat treatment temperature and the heat treatment time are set in such a way that the product between the heat treatment temperature and the heat treatment time is 500 (°C.hour) or less. Incidentally, the heat treatment can be conducted, for example, by use of a reflow oven.

By selecting the composition recommended by the present invention, and by carrying out the heat treatment under the above described conditions, the absolute value of Δk15 can be made to be 2.0% or less, and furthermore, 1.0% or less as the case may be. Similarly to the case of Δk15, the heat treatment carried out under the above described conditions leads to satisfactory values both for ΔF0 and ΔFr. More specifically, the piezoelectric ceramic composition of the present invention can have, concurrently with the property such that the absolute value of Δk15 is 3.0% or less, properties such that the absolute value of ΔF0 is 0.1% or less (-0.1% ≤ ΔF0 ≤ 0.1%) and the absolute value of ΔFr is 0.1% or less (-0.1% ≤ ΔFr ≤ 0.1%). Accordingly, the piezoelectric ceramic composition according to the present invention can be suitably used as the piezoelectric elements for use in, for example, resonators, filters, actuators, ignition elements, supersonic motors and the like. Particularly, there can be suitably used as a resonator the piezoelectric ceramic composition of the present invention, having a Curie temperature Tc as high as 340°C or above, and simultaneously having an absolute value of Δk15 as low as 3.0% or less and an absolute value of ΔF0 as low as 0.1% or less. Here, it should be noted that the values of ΔF0 and ΔFr in the present invention have been obtained on the basis of the above described test of "24-hours after heat test" applied to Δk15.

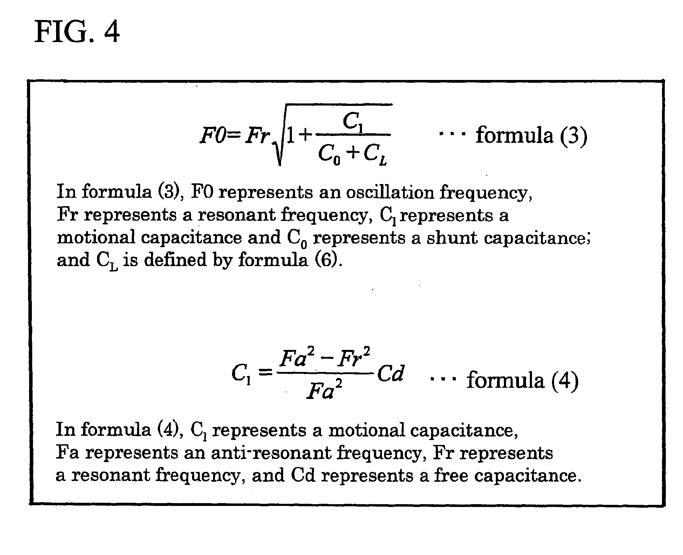

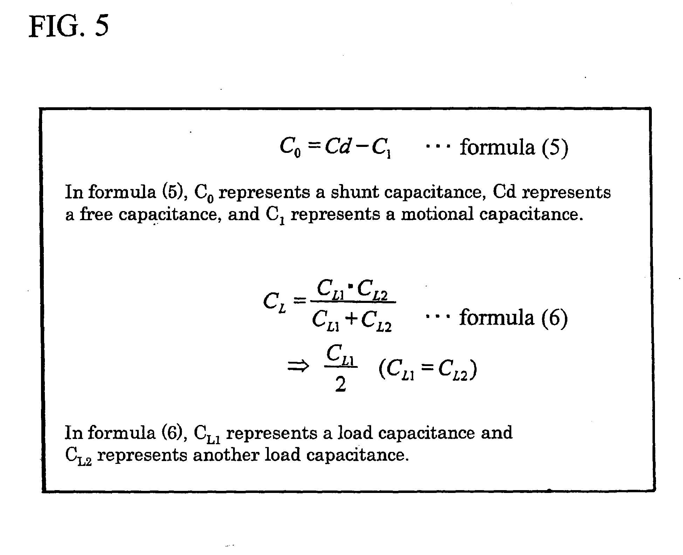

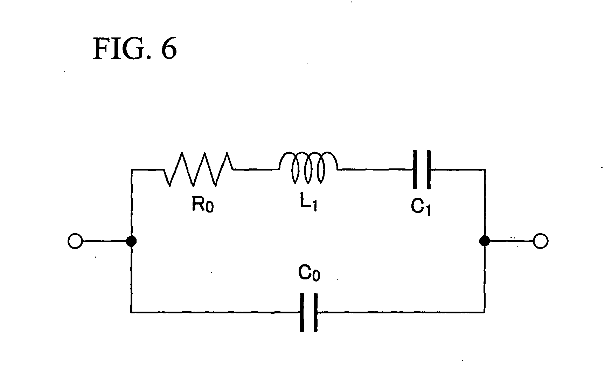

The oscillation frequency F0 in the present invention is related to formulas (3) to (6) shown in FIG. 4 and FIG. 5 in terms of the equivalent circuit constants. In this connection, an equivalent circuit for the piezoelectric resonator is shown in FIG. 6. In FIG. 6, R₀ denotes the resonant impedance, L₁ denotes the equivalent inductance, C₁ denotes the equivalent capacitance, and C₀ denotes the damping capacitance. As shown by formula (3), the oscillation frequency F0 is dependent on the four parameters, namely, the resonant frequency Fr, the motional capacitance C₁, the shunt capacitance C₀, and C_{L}. Additionally, as shown by formulas (4) to (6), the motional capacitance C₁, the shunt capacitance C₀, and C_{L} each are associated with plural parameters.

### (Example 1)

Piezoelectric ceramic compositions exhibiting thickness -shear mode were prepared under the following conditions, and the properties of the compositions thus obtained were evaluated.

As the starting materials, there were prepared the powders of PbO, TiO₂, ZrO₂, MnCO₃, NB₂O₅, Cr₂O₃ and SiO₂; the starting material powders were weighed out in such a way that the formula, Pb[(Mn_{1/3}Nb_{2/3})0.10Ti_{0.51}Zr_{0.39}]O₃, was satisfied, thereafter in relation to the total amount of these powders, there were added the SiO₂ powder at 0.02 wt% and the Cr₂O₃ powder from 0 to 0.50 wt%, and then the thus obtained mixtures of these powders were subjected to wet mixing or 10 hours by use of a ball mill. The slurries thus obtained were dried to a sufficient level, and were calcined in air in a manner maintained at 850°C for 2 hours. The calcined substances were pulverizied with a ball mill so as to have a mean particle size of 0.6 µm, and then the pulverized powders were dried. The dried powders were added with PVA (polyvinyl alcohol) as a binder in an appropriate content, and were granulated. The granulated powders were compacted under a pressure of 245 MPa by use of a uniaxial pressing machine. The compacted bodies thus obtained were subjected to the treatment for removing the binder, and thereafter maintained at 1200°C for 2 hours in the air to obtain sintered bodies each having the size of 17.5 mm long x 17.5 mm wide x 1.5 mm thick. The Curie temperature Tc of these sintered bodies were found to be 357°C.

The both surfaces of each of the sintered bodies were polished so as for the thickness thereof to be 0.5 mm, and from each of the sintered bodies thus processed, a 15 mm long x 5 mm wide specimen was obtained by use of a dicing saw. The electrodes for polarization were formed on the both edge faces (the side faces along the lengthwise direction) of each of the specimens. Thereafter, the specimens each were subjected to a polarization in which each of the specimens was immersed in a silicon oil bath at 150°C, and applied an electric field of 3.0 kV/mm for 1 minute. Here, it should be noted that the polarization direction was chosen as shown in FIG. 3A. Subsequently, the electrodes for polarization were removed. Here, it should also be noted that the size of each of the specimens after removing the electrodes was 15 mm long x 4 mm wide x 0.5 mm thick.

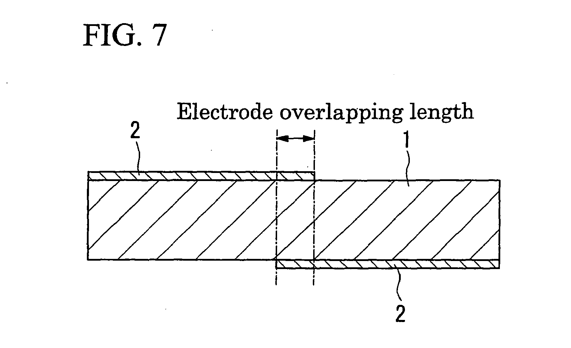

Next, both surfaces of each of the specimens were polished so as for the thickness of each of the specimens to be 0.3 mm, and then, vibrating electrodes (electrodes) 2 were formed on both surfaces (both polished surfaces) of each of the specimens (piezoelectric substrates, sintered bodies) 1 with the aid of a vacuum evaporation apparatus, as shown in FIG. 7. The vibrating electrodes 2 were each formed of a 0.01 µm thick Cr sublayer and a 2 µm thick Ag layer. Incidentally, FIG. 7 illustrates a sectional view (a sectional view along the thickness direction) of each of the specimens 1. The overlapping area of each of the electrodes 2 was made to be 1.5 mm long along the lengthwise direction.

Subsequently, from each of the above described specimens, a 4 mm long x 0.7 mm wide x 0.3 mm thick piezoelectric element was cut out. The piezoelectric elements thus obtained were subj ected to the k15 measurement. The k15 values were measured by use of an impedance analyzer (4294A manufactured by Agilent Technologies Co., Ltd.).

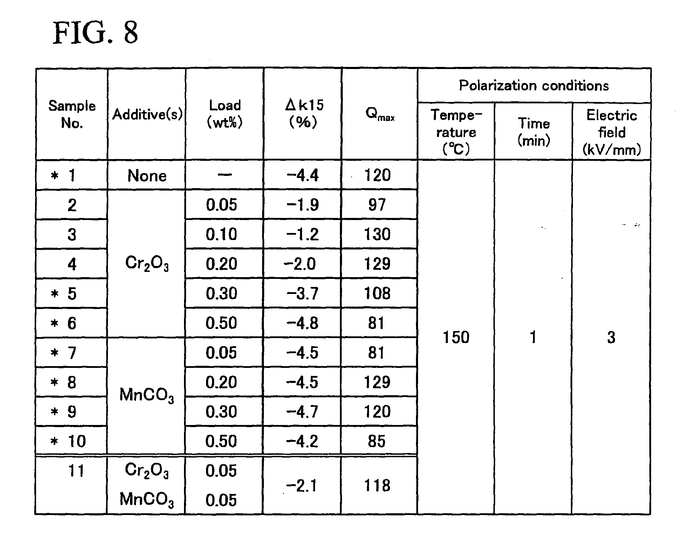

Next, after the above described test for heat resisting properties, the k15 values were once again measured, and the Δk15 values were derived on the basis of the above described formula (2). The results thus obtained are shown in FIG. 8. In the following examples, Δk15 values were determined in the same way.

### (Comparative Examples)

The elements as the comparative examples were prepared under the same conditions as those described above except that MnCO₃ was added as an additive from 0.05 to 0.50 wt% in place of Cr₂O₃. For the elements of the comparative examples, the Δk15 values were obtained under the same conditions as those described above. The obtained results are also shown in FIG. 8.

As shown in FIG. 8, the samples (samples Nos. 7 to 10) containing Mn as an additive each exhibited a Δk15 value comparable with the Δk15 value of the case containing no subsidiary component (sample No. 1). On the contrary, the samples according to the present invention (samples Nos. 2 to 4) each containing a predetermined content of Cr as an additive displayed excellent heat resisting properties such that the Δk15 values were 3.0% or less in absolute value, and more specifically 2.5% or less. However, when the Cr₂O₃ content was 0.10 wt% (sample No. 3), the Δk15 value reached a minimum, and then, the absolute Δk15 value was gradually increased with increasing Cr₂O₃ content in such a way that the absolute Δk15 value exceeded 3.0% when the Cr₂O₃ content came to be 0.30 wt% (sample No. 5). Accordingly, for the purpose of enjoying the effect of improving heat resisting properties provided by containing Cr, the Cr₂O₃ content is made to be 0.25 wt% or less, preferably 0.025 to 0.200 wt%.

Next, when paying attention to the column of Qₘₐₓ, the specimens (samples Nos. 2 to 4) according to the present invention each containing a predetermined content of Cr₂O₃ as an additive, all displayed satisfactory values of 90 or more. In particular, the samples Nos. 3 and 4 each displayed a Qₘₐₓ value higher than that of the case containing no subsidiary component (sample No. 1), so that it can be said that the inclusion of a predetermined content of Cr is effective in improving the Qₘₐₓ value. Incidentally, a Qₘₐₓ value of 30 or more can be said to be a sufficiently practical value.

From the above described results, it has been found that the inclusion of a predetermined content of Cr is effective in improving the heat resisting properties. In Example 1, the piezoelectric elements were prepared without applying heat treatment; however, the inclusion of the predetermined contents of Cr made it possible to obtain the piezoelectric elements excellent in heat resisting properties.

FIG. 8 also shows the properties of sample No. 11 in which Cr₂O₃ and MnCO₃ were added in combination each at 0.05 wt%; in those cases where Mn was added alone as an additive, the effect of the heat resisting properties improvement was not able to be obtained; however, the inclusion of Mn in combination with Cr made it possible to obtain a satisfactory absolute Δk15 value of 2.1%.

### (Example 2)

In Example 1, the piezoelectric elements were prepared without applying any heat treatment. The experiments, carried out for the purpose of checking the properties obtained in the cases where predetermined contents of Cr were contained and additionally heat treatment was applied, are described below as Example 2.

Piezoelectric elements (samples Nos. 12 to 14) were obtained in the same manner as that in Example 1, except that the heat treatment was carried out in air under the following conditions, after the sintered bodies were prepared and polarized. It should be noted that the heat treatment was carried out after the polarization and before the formation of the vibrating electrodes.
Heat treatment temperature: 305°C
Heat treatment time: 10 minutes

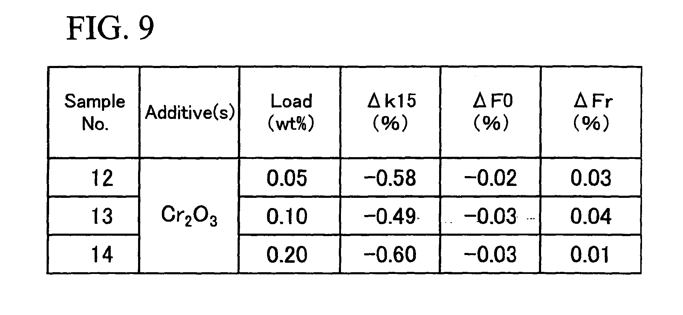

FIG. 9 shows the results of the Δk15, ΔF0 and ΔFr values obtained for the thus obtained samples Nos. 12 to 14. Here, the Δk15 values were obtained by carrying out the same test for heat resisting properties as that in Example 1. The ΔF0 values were obtained on the basis of the above described formulas (3) to (6) (as the oscillation circuit, the Colpitz oscillation circuit was used) . Additionally, in formula (3), it was set that C_{L1} = C_{L2} = 22 pF (C_{L} = 11 pF) . Here, C_{L} was supplied from a member other than the piezoelectric element, and accordingly displayed no change on going from the condition prior to the heat resisting properties test to the condition subsequent to the heat resisting properties test. The oscillation frequency F0 values were measured by use of a frequency counter (53181A manufactured by Agilent Technologies Co., Ltd.), and the resonant frequency Fr values were measured by use of an impedance analyzer (4294A manufactured by Aligent Technologies Co., Ltd.).

As shown in FIG. 9, concurrently with inclusion of Cr as an additive, by carrying out the heat treatment recommended by the present invention, it was made possible to make Δk15 be 1.0% or less in absolute value.

Additionally, it was able to be confirmed that ΔF0 and ΔFr displayed excellent properties such that the absolute values of these quantities were 0.1% or less.

### (Example 3)

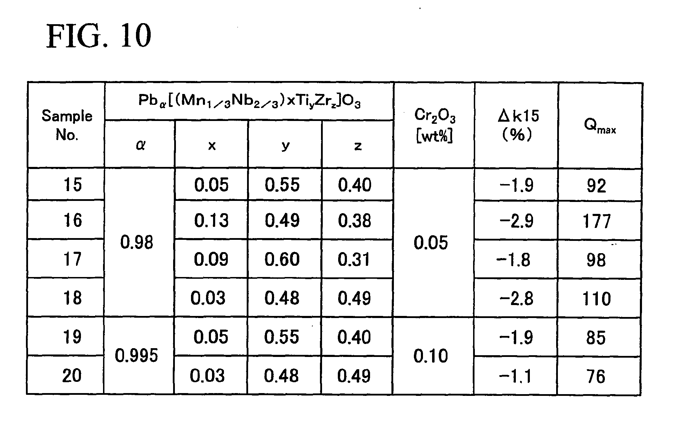

Piezoelectric elements were prepared under the same conditions as those for the samples Nos. 2 to 4 except that the main component contents and the additive contents were set as shown in FIG. 10; the Δk15 and Qₘₐₓ values of the piezoelectric elements thus prepared were obtained under the same conditions as those in Example 1. The obtained results are shown FIG. 10.

As can be seen from FIG. 10, even when the compositions were varied within the scope of the present invention, there obtained Δk15 of 3.0% or less in absolute value and Qₘₐₓ value of 30 or more.

In the above described examples, there have been illustrated the cases where are obtained the piezoelectric elements each having the thickness-shear mode as the vibrational mode; however, by setting the polarization direction and the like to be a predetermined direction, it is of course possible to obtain a piezoelectric element having the thickness-extensional mode and the overtone modes thereof.

## Claims

1. A piezoelectric ceramic composition comprising a perovskite compound comprising Pb, Zr and Ti as main components, wherein said piezoelectric ceramic composition comprises Cr as an additive from 0.025 to 0.250 wt% in terms of Cr₂O₃.

2. A piezoelectric ceramic composition comprising a perovskite compound comprising Pb, Zr, Ti, Mn and Nb as main components, wherein:
said piezoelectric ceramic composition is represented by a formula, Pb_{α}[(Mn_{1/3}Nb_{2/3})ₓTi_{y}Zr_{z}]O₃, where α, x, y and z fall within the ranges of 0.95 ≤ α ≤ 1.02, 0.02 ≤ x ≤ 0.15, 0.48 ≤ y ≤ 0.62, and 0.30 ≤ z ≤ 0.50, respectively; and
said piezoelectric ceramic composition comprises Cr as an additive from 0.025 to 0.250 wt% in terms of Cr₂O₃.

3. The piezoelectric ceramic composition according to claim 1 or 2, wherein:
said piezoelectric composition comprises Cr as an additive from 0.030 to 0.200 wt% in terms of Cr₂O₃.

4. The piezoelectric ceramic composition according to claim 1 or 2, wherein:
Δk15 (here, Δk15 is the rate of change in electromechanical coupling factor k15, caused by external thermal shock) of said piezoelectric ceramic composition is 3.0% or less in absolute value.

5. The piezoelectric ceramic composition according to claim 1 or 2, wherein:
Δk15 (here, Δk15 is the rate of change in electromechanical coupling factor k15, caused by external thermal shock) of said piezoelectric ceramic composition is 2.5 % or less in absolute value.

6. The piezoelectric ceramic composition according to claim 1 or 2, wherein:
the Qₘₐₓ value of said piezoelectric ceramic composition is 30 or more.

7. The piezoelectric ceramic composition according to claim 1 or 2, wherein:
the Qₘₐₓ value of said piezoelectric ceramic composition is 50 or more.

8. The piezoelectric ceramic composition according to claim 1 or 2, wherein:
ΔF0 (here, ΔF0 is the rate of change in oscillation frequency F0, caused by external thermal shock), of said piezoelectric ceramic composition is 0.1% or less in absolute value.

9. The piezoelectric ceramic composition according to claim 1 or 2, wherein:
the Curie temperature Tc of said piezoelectric ceramic composition is 340°C or higher.

10. A piezoelectric element comprising:
a piezoelectric substrate having a front surface and a back surface opposed to each other with a predetermined distance between them, and
a pair of electrodes arranged on said front surface and said back surface of said piezoelectric substrate, respectively, wherein:
said piezoelectric substrate is constituted with a sintered body comprising a perovskite compound comprising Pb, Zr, Ti, Mn and Nb as main components;
said sintered body is represented by a formula, Pb_{α}[(Mn_{1/3}Nb_{2/3})ₓTi_{y}Zr_{z}]O₃, where α, x, y and z fall within the ranges of 0.95 ≤ α ≤ 1.02, 0.02 ≤ x ≤ 0.15, 0.48 ≤ y ≤ 0.62, and 0.30 ≤ z ≤ 0.50, respectively; and
the sintered body comprises Cr as an additive from 0.025 to 0.250 wt% in terms of Cr₂O₃.

11. The piezoelectric element according to claim 10, wherein:
Δk15 (here, Δk15 is the rate of change in electromechanical coupling factor k15, caused by external thermal shock), of said piezoelectric substrate is 3.0 % or less in absolute value.

12. The piezoelectric element according to claim 10, wherein:
the vibrational mode of said piezoelectric element is a thickness-shear mode.

13. The piezoelectric element according to claim 10, wherein:
said piezoelectric substrate is constituted with a sintered body comprising Mn as an additive from 0.20 wt% or less (not inclusive of 0) in terms of MnCO₃.
